# EUROPÄISCHE PATENTANMELDUNG

(11) **EP 1 453 366 A1**
(43) Veröffentlichungstag der Anmeldung: **01.09.2004**
(21) Anmeldenummer: 03004554.6
(22) Anmeldetag: 28.02.2003
(51) Int. Cl.: H05K 7/20, H05K 5/02

(54) **Elektronisches Gerät mit sicherer Wärmeableitung**

(71) Anmelder: SIEMENS AKTIENGESELLSCHAFT, 80333 München (DE)
(72) Erfinder: Apfelbacher, Walter, 92271 Freihung (DE); Kurbjuweit, Thomas, 92224 Amberg (DE); Lehmeier, Annemarie, 92289 Ursensollen (DE); Reichenbach, Norbert, 92224 Amberg (DE)

(57) **Zusammenfassung**

Um bei einem elektronischen Gerät (1) eine sichere Wärmeableitung zu erzielen, ist ein mehrteiliges Gehäuse (2), umfassend eine Gehäuseschale (3) und einen Gehäusedeckel (4), vorgesehen, wobei an einer Grundplatte (19) der Gehäuseschale (3) eine mit mindestens einem elektronischen Leistungsbauteil (7) bestückte Trägerplatte (26) angeordnet ist, wobei der Gehäusedeckel (4) eine Montageeinrichtung (11,12) zur Befestigung des Gehäuses (2) auf einem Kühlkörper (13) unter Anpressung der Trägerplatte (26) an einer Auflagefläche (27) des Kühlkörpers (13) trägt, und wobei mindestens ein Stützelement (24,25,31,32) zur Übertragung einer in Richtung der Grundplatte (19) gerichteten Anpresskraft (F) vom Gehäusedeckel (4) auf die Gehäuseschale (3) vorgesehen ist.

## Beschreibung

Die Erfindung bezieht sich auf ein elektronisches Gerät, z.B. ein elektronisches Schaltgerät.

Ein derartiges Gerät beinhaltet üblicherweise einen elektronischen Schaltkreis, der mit einem oder mehreren elektronischen Leistungsbauteilen, beispielsweise einem MOSFET, einer Leistungsdiode o.dgl. versehen ist. Ein solches Leistungsbauteil erzeugt auch im bestimmungsgemäßen Gebrauch eine erhebliche Verlustwärme, die aus dem Gehäuse des Geräts abgeleitet werden muss, um eine Überhitzung des Schaltkreises zu vermeiden. Um eine gute Ableitung der Verlustwärme sicherzustellen, ist es üblich, das Gerät auf einem insbesondere metallischen Kühlkörper zu montieren. Ein guter Wärmeübergang vom Gerät auf diesen Kühlkörper wird dadurch erzielt, dass eine mit dem oder den Leistungsbauteilen bestückte Trägerplatte direkt in das Gehäuse des Geräts integriert wird. Die Trägerplatte ist hierbei zweckmäßigerweise in einer Grundplatte des Gehäuses vorgesehen, welche in montiertem Zustand direkt an einer Auflagefläche des Kühlkörpers anliegt. Zumal die thermische Verbindung zwischen der Trägerplatte und dem Kühlkörper um so besser ist, je gleichmäßiger und großflächiger die Trägerplatte auf dem Kühlkörper aufliegt, wird das Gerät gewöhnlicher weise auf dem Kühlkörper verschraubt, wodurch die Trägerplatte gegen die Auflagefläche des Kühlkörpers angepresst wird.

Zur Herstellung dieser Verschraubung sind häufig Laschen am Gehäuse des Geräts angebracht, die dieses insbesondere in Gehäuselängsrichtung überragen. Diese Laschen sind konstruktiv bedingt relativ weit vom Schwerpunkt der Trägerplatte entfernt. Dies bedeutet, dass auch die Befestigungspunkte, an denen das Gerät mit dem Kühlkörper verschraubt ist, relativ weit von der Trägerplatte entfernt sind, wodurch die durch die Verschraubung erzeugte Vorspannung nur ungünstig und verlustreich auf die Trägerplatte übertragen wird. Der ungünstige Kraftübertragungsweg führt zu einer hohen Torsionsbelastung des Gehäuses, die insbesondere am Übergang der Laschen in das Gehäuse sowie im Umfeld der Kanten der Trägerplatte verstärkt auftritt. Aufgrund dieser Materialspannungen kann es vorkommen, dass das Gehäuse und/oder die Trägerplatte geschädigt werden und - im ungünstigsten Fall - sogar brechen.

Zur Überwindung der besagten Materialverspannungen wird bisweilen die Trägerplatte flächig mit einer metallischen Montageplatte verlötet, welche dann wiederum auf dem Kühlkörper verschraubt wird. Das Auflöten der Trägerplatte auf die Montageplatte erfordert jedoch in nachteiliger Weise einen zusätzlichen und zeitaufwändigen Fertigungsschritt. Die Montageplatte stellt des Weiteren ein Zusatzteil des Geräts dar, welches zum einen die Herstellungskosten des Geräts erhöht und zum anderen dessen Bauvolumen vergrößert.

Der Erfindung liegt die Aufgabe zugrunde, ein elektronisches Gerät anzugeben, bei dem unter Vermeidung der genannten Nachteile eine sichere Wärmeableitung ermöglicht ist.

Diese Aufgabe wird erfindungsgemäß gelöst durch die Merkmale des Anspruchs 1. Danach ist das Gehäuse des Geräts mehrteilig ausgeführt und umfasst eine Gehäuseschale sowie einen Gehäusedeckel, welcher auf die Gehäuseschale schuhschachtelartig aufgestülpt ist. Die Gehäuseschale weist hierbei eine zur Anlage an einen Kühlkörper vorgesehene Grundplatte auf, in die eine mit mindestens einem elektronischen Leistungsbauteil bestückte Trägerplatte eingesetzt ist. Der Gehäusedeckel wiederum ist mit einer Montageeinrichtung zur Befestigung des Gehäuses auf einem Kühlkörper und damit zur Anpressung der Trägerplatte an einer Auflagefläche des Kühlkörpers versehen. Die von der Montageeinrichtung erzeugte Anpresskraft wird hierbei über mindestens ein Stützelement vom Gehäusedeckel auf die Gehäuseschale übertragen.

Durch die mehrteilige, insbesondere zweiteilige Gehäuseausführung erhält das Gehäuse eine Flexibilität, durch die unsymmetrische Materialverspannungen etwa gleichmäßig innerhalb über das Gehäuse verteilt werden. In anderen Worten können bei einer lokal auftretenden Materialverspannung die insbesondere zwei Gehäuseteile gegeneinander arbeiten, so dass eine Überbelastung lokaler Gehäusebereiche vermieden wird. Dies führt insbesondere dazu, dass eine auf das Gerät ausgeübte Anpresskraft besonders gleichmäßig auf die Grundplatte abgeleitet wird, wodurch die flächige Anlage der in der Grundfläche integrierten Trägerplatte auf der Auflagefläche des Kühlkörpers sichergestellt ist.

Über das mindestens eine Stützelement ist eine besonders gezielte Übertragung der Anpresskraft auf die Gehäuseschale möglich. Wie nachfolgend näher ausgeführt, sind bevorzugt mehrere Stützelemente vorgesehen, die symmetrisch um die Trägerplatte herum und möglichst nah an der Trägerplatte angeordnet sind. Hierdurch wird eine besonders gute, gleichmäßige und somit Material schonende Anpressung der Trägerplatte am Kühlkörper erreicht.

Der Gehäusedeckel und die Gehäuseschale sind bevorzugt miteinander verrastet. Die beiden Gehäuseteile sind damit sowohl im montierten als auch im unmontierten Zustand verliersicher aneinander gehalten. Andererseits wird durch die Rastverbindung die vorteilhafte Flexibilität des Gehäuseaufbaus nicht unterdrückt.

In zweckmäßiger Ausführung umfasst die Montageeinrichtung mindestens zwei Befestigungsschrauben, deren jede in einer zugehörigen Schraubenführung des Gehäusedeckels geführt und widergelagert ist. Um die Befestigungspunkte, an denen das Gerät am Kühlkörper befestigt ist, zur Verbesserung des Kraftübertragungswegs möglichst nah an die Trägerplatte heranzubringen, ist jede Schraubenführung durch den Gehäuseinnenraum hindurchgeführt. Diese Konstruktionsweise ist insbesondere besonders günstig im Hinblick auf die in montiertem Zustand auf das Gehäuse wirkende Torsionsbelastung. Die Schraubenführung dient zusätzlich zur elektrischen Isolation der Befestigungsschrauben gegenüber dem Gehäuseinnenraum.

Vorteilhafterweise sind ein oder mehrere Stützelemente im Bereich der Seitenwände des Gehäuses angeordnet. Als Seitenwände des Gehäuses sind hierbei die beiden in Gehäuselängsrichtung ausgerichteten Gehäusewände bezeichnet, welche von der Grundplatte abgewinkelt sind. Diese Seitenwände flankieren die Querseiten der Trägerplatte, sind also in Längsrichtung der Trägerplatte ausgerichtet. Die Seitenwände sind daher vergleichsweise nah am Schwerpunkt der Trägerplatte angeordnet, wodurch eine vergleichsweise zentrale Kraftübertragung auf die Trägerplatte möglich ist.

Infolge der zweiteiligen Ausführung des Gehäuses überlappen sich die beiden Gehäuseteile, also der Gehäusedeckel und die Gehäuseschale, im Bereich der Seitenwände. Jede Seitenwand des Gehäuses umfasst somit schichtartig aneinander liegend eine Seitenwand des Gehäusedeckels sowie eine zugehörige Seitenwand der Gehäuseschale. Bevorzugt umfasst das oder jedes einer Seitenwand des Gehäuses zugeordnete Stützelement einen an einem ersten Gehäuseteil angeformten Stützvorsprung, der an einer korrespondierende Stützkontur in der Seitenwand des zweiten Gehäuseteils angreift. Als erstes, den Stützvorsprung tragendes Gehäuseteil ist vorzugsweise die Gehäuseschale gewählt, während der Gehäusedeckel als zweites Gehäuseteil die Stützkontur trägt. Es ist äquivalentermaßen jedoch auch möglich, den Stützvorsprung am Gehäusedeckel anzubringen und eine Stützkontur an der Gehäuseschale vorzusehen. Bevorzugt ist weiterhin jeweils ein Stützelement etwa längszentriert bezüglich jeder Seitenwand vorgesehen. Es können weiterhin jedoch auch mehrere Stützelemente pro Seitenwand angeordnet sein.

Die Seitenwände bilden die größten ebenen Flächen der Gehäusekonstruktion. Sie sind daher naturgemäß vergleichsweise instabil im Hinblick auf innerhalb des Gehäuses wirkende Druckspannungen. Um auszuschließen, dass sich die Seitenwände unter Wirkung der Anpresskraft verbiegen, wodurch das oder die in der Seitenwand angeordneten Stützelemente aus ihrer Stützposition abrutschen könnten, ist der oder jeder Stützvorsprung bevorzugt nach Art einer Hinterschneidung ausgebildet. Darunter wird verstanden, dass die Stützkante eines jeden Stützvorsprungs unter einem spitzen Winkel aus der zugehörigen Seitenwand hervorsteht und in Stützstellung die anliegende Stützkontur des zweiten Gehäuseteils hintergreift. Auf diese Weise werden die aneinander anliegenden Seitenwände um so stärker aneinander gepresst, je stärker die Anpresskraft ist. Die aneinander anliegenden Seitenwände der beiden Gehäuseteile stabilisieren sich unter Wirkung der Anpresskraft somit gegenseitig. Zur weiteren Versteifung des Gehäuses ist vorgesehen, dass die Gehäuseschale und/oder der Gehäusedeckel insbesondere im Bereich der Seitenwände mit Versteifungsrippen versehen sind.

Um auch im Bereich der Stirnseiten der Trägerplatte eine gute Kraftübertragung zu erzielen, ist in vorteilhafter Ausführung auch im Bereich der oder jeder Schraubenführung ein Stützelement angeordnet. Dieses Stützelement umfasst einen aus der Schraubenführung hervorstehenden Radialvorsprung, insbesondere eine stufenförmige Verbreiterung der Schraubenführung, der mit einem korrespondierenden Anschlag der Gehäuseschale, insbesondere in Form eines hohlzylindrischen Vorsprungs, zusammenwirkt.

Zur weiteren Verbesserung der Auflage der Trägerplatte auf dem Kühlkörper ist weiterhin vorgesehen, dass die Trägerplatte leicht über die Grundplatte in den Gehäuseaußenraum hervorsteht. Für eine besonders gute und gleichmäßige Übertragung der Anpresskraft auf die Trägerplatte ist die oder jede Schraubenführung in Gehäuselängsrichtung unmittelbar oder mit geringem Abstand zu der Trägerplatte angeordnet. Darüber hinaus ist die Trägerplatte.von der Grundplatte zweckmäßigerweise vollständig eingerahmt, um die Anpresskraft gleichmäßig von der Gehäuseschale auf die Trägerplatte zu übertragen.

Nachfolgend wird ein Ausführungsbeispiel der Erfindung anhand einer Zeichnung näher erläutert. Darin zeigen:
- FIG 1: in Explosionsdarstellung ein elektronisches Gerät mit einem eine Gehäuseschale und einen Gehäusedeckel umfassenden Gehäuse und einer in die Gehäuseschale integrierten Trägerplatte für elektronische Leistungsbauteile,
- FIG 2: in perspektivischer Darstellung das Gerät gemäß FIG 1 in zusammengebautem Zustand und
- FIG 3: in einem Längsschnitt das Gerät gemäß FIG 2.

Einander entsprechende Teile sind in allen Figuren mit den gleichen Bezugszeichen versehen.

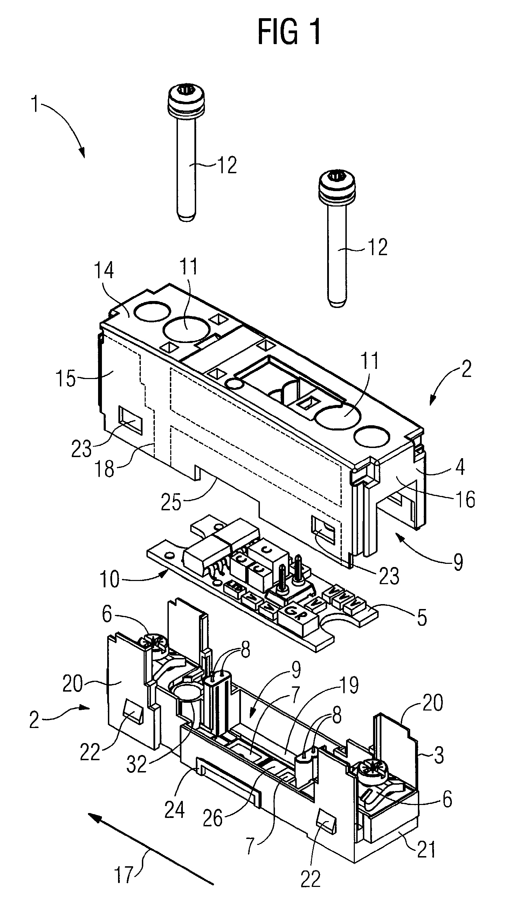

Bei dem in FIG 1 in Explosionsdarstellung gezeigten elektronischen Gerät 1 handelt es sich beispielsweise um ein Schaltgerät. Das Gerät 1 ist mit einem isolierenden Gehäuse 2 versehen. Das Gehäuse 2 ist zweigeteilt und umfasst eine wannenartige Gehäuseschale 3 und einen ebenfalls wannenartigen Gehäusedeckel 4, der nach Art eines Schuhkartons auf die Gehäuseschale 3 aufstülpbar ist. Das Gerät 1 umfasst weiterhin eine in das Gehäuse 2 einsetzbare Flachbaugruppe 5, d.h. einen plattenartigen Schaltungsträger, der mit Elementen einer elektronischen Schaltung bestückt ist.

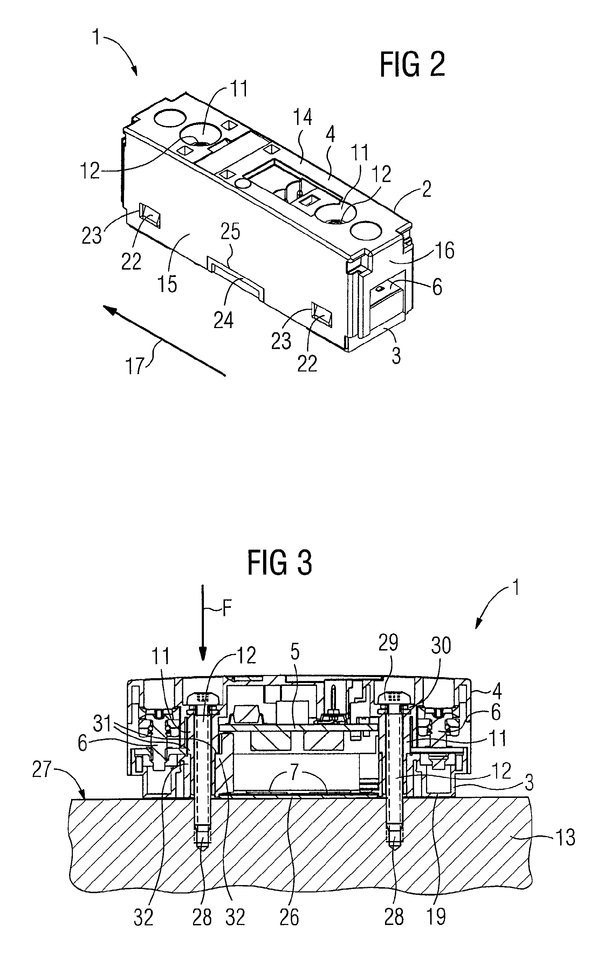

In dem in den FIG 2 und 3 dargestellten zusammengebauten Zustand des Geräts 1 ist die Flachbaugruppe 5 mit zwei in der Gehäuseschale 3 angeordneten Kontaktklemmen 6 und weiteren, ebenfalls in der Gehäuseschale 3 angeordneten elektronischen Leistungsbauteilen 7 elektrisch verbunden. Der Kontakt zwischen diesen aus der Flachbaugruppe 5 ausgelagerten Schaltungselementen, d.h. den Kontaktklemmen 6 und den Leistungsbauteilen 7, und der Flachbaugruppe 5 wird über Stiftkontakte 8 vermittelt, welche von der Gehäuseschale 3 in den Gehäuseinnenraum 9 hineinragen und die Flachbaugruppe 5 an deren Unterseite 10 kontaktieren.

Der Gehäusedeckel 4 ist mit zwei Schraubenführungen 11 versehen, in die jeweils eine Befestigungsschraube 12 eingesetzt ist. Die Schraubenführungen 11 haben, vereinfacht ausgedrückt, jeweils etwa die Form hohlzylindrischer Vorsprünge, die vom Gehäusedeckel 4 in den Gehäuseinnenraum 9, und in Richtung der Gehäuseschale 3 abragen und den gesamten Gehäuseinnenraum 9 durchziehen. Die Befestigungsschrauben 12 können somit entlang der Schraubenführungen 11 durch das Gehäuse 2 hindurch gesteckt werden und dienen der Verschraubung des Geräts 1 an einer Unterlage, insbesondere einem Kühlkörper 13 (FIG 3). Die Befestigungsschrauben 12 und die zugehörigen Schraubenführungen 11 werden deshalb zusammenfassend auch als Montageeinrichtung bezeichnet.

Der Gehäusedeckel 4 umfasst eine zentrale, etwa rechteckige Deckelfläche 14, von deren Kanten zwei Seitenwände 15 und zwei Stirnwände 16 etwa rechtwinklig abgewinkelt sind. Die Seitenwände 15 sind hierbei in Gehäuselängsrichtung 17 orientiert, während die Stirnwände 16 senkrecht dazu orientiert sind. Die Seitenwände 15 und Stirnwände 16 sind wiederum an ihren angrenzenden Kanten miteinander verbunden, so dass der Gehäusedeckel 4 vereinfacht die Form eines an seiner Unterseite offenen Hohlquaders aufweist. Der Gehäusedeckel 4 ist durch diese Formgebung insbesondere stabil gegenüber einer Druck- oder Torsionsbelastung. Zur weiteren Versteifung des Gehäusedeckels 4 sind die Seitenwände 15 mit Versteifungsrippen 18 versehen. Die Versteifungsrippen 18 sind auf der dem Gehäuseinnenraum 9 zugewandten Seite der Seitenwände 15 angeformt. Sie sind daher in der perspektivischen Darstellung gemäß FIG 1 verborgen und aus diesem Grund nur als gestrichelte Linien angedeutet.

Die Gehäuseschale 3 weist eine zentrale, der Deckelfläche 14 des Gehäusedeckels 4 entgegengesetzte, Grundplatte 19 auf, von welcher ähnlich dem Gehäusedeckel 4 Seitenwände 20 und, als Durchlass für die Kontaktklemmen 6 stark eingeschnittene, Stirnwände 21 etwa rechtwinklig abgewinkelt sind.

Im zusammengebauten Zustand des Geräts 1 ist die Flachbaugruppe 5 in das Gehäuse 2 (FIG 3) eingelegt, und die Gehäuseschale 3 mit dem aufgestülpten Gehäusedeckel 4 verrastet. Hierzu dienen an der Gehäuseschale 3 angebrachte Rastnasen 22, deren jede in eine entsprechend im Gehäusedeckel 4 eingebrachte Aufnahme 23 eingreift. In zusammengebautem Zustand liegt weiterhin ein von jeder Seitenwand 20 nach außen abragender Stützvorsprung 24 formschlüssig in einer in jede Seitenwand 15 eingeschnittenen Stützkontur 25 ein. Der Stützvorsprung 24 ist dabei nach Art einer Hinterschneidung gestaltet, so dass er die Seitenwand 15 im Bereich der Stützkontur 25 hintergreift.

Das Gerät 1 ist insbesondere dahingehend ausgestaltet, dass die von den Leistungsbauteilen 7 im Betrieb des Geräts 1 erzeugte Verlustwärme sicher aus dem Gerät 1 abgeführt werden kann. Hierzu sind die Leistungsbauteile 7 auf einer insbesondere keramischen Trägerplatte 26 aufgebaut, welche wiederum in die Grundplatte 19 der Gehäuseschale 3 unlösbar integriert ist. Die Trägerplatte 26 ist hierzu von außen in eine fensterartige Öffnung der Grundplatte 19 eingesetzt und mit der Gehäuseschale 3 bevorzugt verklebt. Die Gehäuseschale 3 überlappt mit der Trägerplatte 26 in deren gesamten Randbereich, so dass die Trägerplatte 26 von der Gehäuseschale 3 vollständig eingerahmt ist. Wird, wie in FIG 3 dargestellt, das Gerät 1 mit der Grundplatte 19 auf den Kühlkörper 13 aufgesetzt, so liegt die Trägerplatte 26 auf der Auflagefläche 27 des Kühlkörpers 13 auf, wodurch die in den Leistungsbauteilen 7 erzeugte Verlustwärme über die dünne Trägerplatte 26 direkt in den Kühlkörper 13 abfließen kann. Der Trägerplatte 26 und dem Kühlkörper 13 ist optional nach herkömmlicher Technik eine nicht näher dargestellte Wärmeleitfolie oder Wärmeleitpaste zur Verbesserung des Wärmeübergangs zwischengeschichtet.

Für einen guten thermischen Kontakt zwischen der Trägerplatte 26 und dem Kühlkörper 13 ist es wichtig, dass die Trägerplatte 26 unter Vorspannung und möglichst großflächig auf der Auflagefläche 27 aufliegt. Hierbei soll die Trägerplatte 26 möglichst gleichmäßig gegen die Auflagefläche 27 gedrückt werden, um eine schädigende Materialverspannung zu vermeiden. Die nötige Anpresskraft F wird dadurch erzeugt, dass die Befestigungsschrauben 12 in entsprechend in den Kühlkörper 13 eingebrachten Gewindebohrungen 28 eingeschraubt werden. Die Anpresskraft F wird hierbei über ein mit dem Schraubenkopf 29 jeder Befestigungsschraube 12 korrespondierendes Widerlager 30 der Schraubenführungen 11 auf den Gehäusedeckel 4 übertragen. Vom Gehäusedeckel 4 wird die Anpresskraft F über nachfolgend näher beschriebene Stützelemente auf die Gehäuseschale 3 übertragen. Die Gehäuseschale 3 wiederum überträgt die Anpresskraft F zumindest teilweise auf die Trägerplatte 26, die dadurch gegen die Auflagefläche 27 vorgespannt wird. Ein Teil der Anpresskraft F wird des Weiteren über die Grundplatte 19 der Gehäuseschale 3 auf den Kühlkörper 13 übertragen.

Eines der besagten Stützelemente ist durch den Stützvorsprung 24 und die korrespondierende Stützkontur 25 gebildet (FIG 2). Mittels des Stützvorsprungs 24 und der korrespondierenden Stützkontur 25 wird die Anpresskraft F vorteilhafterweise über jedes Paar von Seitenwände 15 und 20 übertragen. Diese Kraftübertragung erfolgt hierdurch nahe den Querrändern der Trägerplatte 26 und insofern vergleichsweise nah am Schwerpunkt der Trägerplatte 26, was im Hinblick auf den Kraftübertragungsweg besonders günstig ist. Je ein zusätzliches Stützelement ist in im Bereich jeder Schraubenführung 11 angeordnet und umfasst einen als stufenartige Verbreiterung ausgebildeten Radialvorsprung 31 und einen korrespondierenden Anschlag 32, der als etwa hohlzylindrisch in den Gehäuseinnenraum 9 hineinragender Vorsprung der Gehäuseschale 3 ausgebildet ist und der die zugehörige Schraubenführung 11 konzentrisch umfasst. Die durch jeweils einen Radialvorsprung 31 und einen korrespondierenden Anschlag 32 gebildeten Stützelemente sind in Gehäuselängsrichtung 17 dicht an der Trägerplatte 26 angeordnet. Die Anpresskraft F wird also bezüglich der Trägerplatte 26 allseitig und symmetrisch, und damit besonders gleichmäßig vom Gehäusedeckel 4 auf die Gehäuseschale 3, und von dort auf die Trägerplatte 26 übergeben. Hierdurch sind insbesondere punktuelle Materialverspannungen vermieden. Um einen möglichst großen Teil der Anpresskraft F auf die Trägerplatte 26 übertragen zu können, steht diese leicht über die Grundplatte 19 hervor. Die Trägerplatte 26 wird somit quasi zwischen der Grundplatte 19 und der Auflagefläche 27 eingeklemmt.

Der Vorteil des zweiteiligen Gehäuses 2 tritt insbesondere dann zutage, wenn die Befestigungsschrauben 12 unsymmetrisch, d.h. mit unterschiedlich starker Vorspannung, am Kühlkörper 13 verschraubt werden. Zumal die beiden Gehäusehälften aufgrund der vergleichsweise flexiblen Rastverbindung gegeneinander arbeiten können, werden lokale Spannungsspitzen innerhalb des Gehäusematerials vermieden.

## Patentansprüche

1. Elektronisches Gerät (1) mit einem mehrteiligen Gehäuse (2), umfassend eine Gehäuseschale (3) und einen Gehäusedeckel (4), wobei an einer Grundplatte (19) der Gehäuseschale (3) eine mit mindestens einem elektronischen Leistungsbauteil (7) bestückte Trägerplatte (26) angeordnet ist, wobei der Gehäusedeckel (4) eine Montageeinrichtung (11,12) zur Befestigung des Gehäuses (2) auf einem Kühlkörper (13) unter Anpressung der Trägerplatte (26) an einer Auflagefläche (27) des Kühlkörpers (13) trägt, und wobei mindestens ein Stützelement (24,25,31,32) zur Übertragung einer in Richtung der Grundplatte (19) gerichteten Anpresskraft (F) vom Gehäusedeckel (4) auf die Gehäuseschale (3) vorgesehen ist.

2. Elektronisches Gerät (1) nach Anspruch 1, **dadurch gekennzeichnet, dass** die Gehäuseschale (3) und der Gehäusedeckel (4) miteinander verrastet sind.

3. Elektronisches Gerät (1) nach Anspruch 1 oder 2, **dadurch gekennzeichnet, dass** die Montageeinrichtung (11,12) mindestens zwei Befestigungsschrauben (12) und je eine zugehörige Schraubenführung (11) des Gehäusedeckels (4) umfasst, wobei jede Schraubenführung (11) durch den Gehäuseinnenraum (9) hindurchgeführt ist.

4. Elektronisches Gerät (1) nach einem der Ansprüche 1 bis 3, **dadurch gekennzeichnet, dass** das Stützelement (24,25) an einer Seitenwand (15,20) des Gehäuses (2) angeordnet ist.

5. Elektronisches Gerät (1) nach Anspruch 4, **dadurch gekennzeichnet, dass** das Stützelement (24,25) einen an eine Seitenwand (20) eines ersten Gehäuseteils (3) angeformten Stützvorsprung (24) umfasst, der an einer korrespondierenden Stützkontur (25) in der Seitenwand (15) des zweiten Gehäuseteils (4) angreift.

6. Elektronisches Gerät (1) nach Anspruch 5, **dadurch gekennzeichnet, dass** der Stützvorsprung (24) nach Art einer Hinterschneidung ausgebildet ist.

7. Elektronisches Gerät (1) nach einem der Ansprüche 1 bis 6, **dadurch gekennzeichnet, dass** die Gehäuseschale (3) und/oder der Gehäusedeckel (4) mit Versteifungsrippen (18) versehen sind.

8. Elektronisches Gerät (1) nach einem der Ansprüche 2 bis 7, **dadurch gekennzeichnet, dass** das Stützelement (31,32) einen Radialvorsprung (31) der Schraubenführung (11) des Gehäusedeckels (4) umfasst, der mit einem korrespondierenden Anschlag (32) der Gehäuseschale (3) zusammenwirkt.

9. Elektronisches Gerät (1) nach einem der Ansprüche 1 bis 8, **dadurch gekennzeichnet, dass** die Trägerplatte (26) über die Grundplatte (19) nach außen hervorsteht.

10. Elektronisches Gerät (1) nach einem der Ansprüche 2 bis 9, **dadurch gekennzeichnet, dass** die Schraubenführung (11) in Gehäuselängsrichtung (17) unmittelbar oder mit geringem Abstand zu jedem Längsende der Trägerplatte (26) angeordnet ist.

11. Elektronisches Gerät (1) nach einem der Ansprüche 1 bis 10, **dadurch gekennzeichnet, dass** die Grundplatte (19) der Gehäuseschale (3) einen geschlossenen Rahmen für die Trägerplatte (26) bildet.
